# EUROPEAN PATENT SPECIFICATION

(11) **EP 3 510 638 B1**
(45) Date of publication and mention of the grant of the patent: **01.07.2020**
(21) Application number: 17778340.4
(22) Date of filing: 06.09.2017
(51) Int. Cl.: H01L 31/0352, H01L 31/0224, H01L 31/0304, H01L 31/08, C25B 1/06, C01B 3/04, H01G 9/20

(54) **DUAL-SIDED PHOTOELECTRODES AND A METHOD OF MAKING A SUAL-SIDED PHOTOELECTRODE**
DOPPELSEITIGE FOTOELEKTRODEN UND METHODE ZUR HERSTELLUNG EINER DOPPELSEITIGEN PHOTOELEKTRODE
PHOTOÉLECTRODES À DOUBLE FACE ET MÉTHODE DE FABRICATION DE PHOTOÉLECTRODE À DOUBLE FACE

(30) Priority: 08.09.2016 US 201662384947 P
(43) Date of publication of application: 17.07.2019
(60) Divisional application: 20173991.9
(73) Proprietor: King Abdullah University of Science and Technology, Thuwal 23955-6900 (SA)
(72) Inventor: OOI, Boon S., Thuwal 23955-6900 (SA); HUSSEIN, Mohamed Ebaid Abdrabou, Thuwal 23955-6900 (SA); PRABASWARA, Aditya, Thuwal 23955-6900 (SA); NG, Tien Khee, Thuwal 23955-6900 (SA); MIN, Jungwook, Thuwal 23955-6900 (SA)
(74) Representative: Ipsilon
(86) International application number: PCT/IB2017/055376
(87) International publication number: WO 2018/047082

(56) References cited:
- WO-A1-2016/015134
- US-A1- 2012 313 073
- US-B1- 8 388 818
- B. ALOTAIBI ET AL: "A Metal-Nitride Nanowire Dual-Photoelectrode Device for Unassisted Solar-to-Hydrogen Conversion under Parallel Illumination", NANO LETTERS, vol. 15, no. 10, 16 September 2015 (2015-09-16), pages 6821-6828, XP055420548, US ISSN: 1530-6984, DOI: 10.1021/acs.nanolett.5b02671

## Description

### BACKGROUND

Fabricating semiconductor devices on top of cheap, transparent glass substrates would enable novel optoelectronics and energy harvesting applications. One of the possible options includes coating a glass substrate with a transparent conductive oxide (TCO) layer and growing semiconductor material on top of the TCO. This has been demonstrated for various semiconductor materials such as ZnO, TiO₂, and WO₃. However, the materials lack wavelength tunability, limiting their potential for optoelectronic and energy harvesting applications.

US patent application number US 2012/0313073 A1 discloses a sysem comprising a photoanode and a photocathode, joined by an ion-conductive, flexible composite polymer film.

III-Nitride material provides a viable alternative due to the ability to tune the emission wavelength by adjusting the ternary alloy composition. However, to accommodate the lattice mismatch between the III-Nitride thin film and the TCO layer, the crystallinity of the III-Nitride material is typically reduced. Several groups have tried to improve the crystallinity through various methods. Samsung, for example, demonstrated the capability of growing nearly single crystalline GaN on top of glass using a Ti preorienting layer and selective area growth mask. However, this method results in a non-transparent device with added processing complexity. Another group from University of Tokyo demonstrated that it is possible to improve the crystallinity of sputtered InGaN material on top of amorphous glass using graphene as buffer layer.

Spontaneously grown III-Nitride nanowire materials, alternatively, can grow on various lattice-mismatched surface while maintaining excellent crystal quality. These nanowire materials are typically grown catalyst-free using plasma assisted molecular beam epitaxy (PA-MBE) without the need for global epitaxial relationship with the substrate. In addition to good crystal quality, nanowire-based III-Nitride materials can also cover the entire visible spectrum because of reduced internal polarization field, making them attractive for various applications. By directly integrating color-tunable light emitters on transparent substrates and leveraging existing silica photonics technologies, it is possible to develop various applications such as back lighting unit, integrated optofluidic devices, integrated light source and detector within a single silica chip, and dual-sided photoelectrodes for solar hydrogen generation. Various groups have demonstrated the feasibility of growing nitride material on oxides using various methods such as direct growth on fused silica and quartz and iterative SiO₂ deposition and nanowire growth on silicon substrate. Nevertheless, a nanowire based device operating directly on transparent glass substrate has not been reported in previous studies.

### SUMMARY

The present invention relates to photoelectrodes as defined in appended claims 1 and 7 and a method of making a photoelectrode as defined in appended claim 15. Embodiments describe a photoelectrode including a first III-nitride nanowire layer, a transparent substrate in contact with the first nanowire layer at a first substrate surface and a second III-nitride nanowire layer in contact with the substrate at a second substrate surface, substantially opposite the first substrate surface.

Embodiments also include a photoelectrode including a first thin conductive layer, a transparent substrate in contact with the first thin conductive layer at a first substrate surface, a first III-nitride nanowire layer in contact with the first thin conductive layer, a second thin conductive layer in contact with the substrate at a second substrate surface, substantially opposite the first substrate surface, and a second III-nitride nanowire layer in contact with the second thin conductive layer.

Embodiments further include a method of making a photoelectrode for solar water splitting, including growing III-nitride nanowires on a first surface of a transparent, conducting substrate and growing III-nitride nanowires on a second surface of the substrate, the second surface substantially opposite the first surface.

Embodiments describe method of making a photoelectrode for solar water splitting. The method includes depositing a first thin conductive layer on a first surface of a transparent substrate, growing III-nitride nanowires on the first surface, depositing a second thin conductive layer on a second surface of a transparent substrate, and growing III-nitride nanowires on the second surface, the second surface substantially opposite the first surface.

The details of one or more examples are set forth in the description below. Other features, objects, and advantages will be apparent from the description and from the claims.

### BRIEF DESCRIPTION OF DRAWINGS

This written disclosure describes illustrative embodiments that are nonlimiting and non-exhaustive. In the drawings, which are not necessarily drawn to scale, like numerals describe substantially similar components throughout the several views. Like numerals having different letter suffixes represent different instances of substantially similar components. The drawings illustrate generally, by way of example, but not by way of limitation, various embodiments discussed in the present document.

Reference is made to illustrative embodiments that are depicted in the figures, in which:
**FIGS. 1A-B** illustrate a A) schematic illustration of the InGaN-based nanowires on transparent-conducting substrate or template substrate and B) a scanning electron micrograph photograph of the nanowires (HV 5.00 kV; curr 13.3 pA; WD 10.2 mm; mag 100 010 x; HFW 2.98 µm; tilt 0°, Quanta 3D FEG), according to some embodiments.
**FIGS. 2A-C** illustrate light emission spectra (solid line) collected using a confocal micro-Raman spectrometer (Horiba/Jobin Yvon Aramis), with the constituent subcomponents fitted (see legend: PI, P2, and P3 curves), according to some embodiments.
**FIG. 3** is a block flow diagram of a method of making a photoelectrode for solar water splitting, according to some embodiments.
**FIG. 4** is a block flow diagram of a method of making a photoelectrode for solar water splitting, according to some embodiments.
**FIG. 5** is a block flow diagram of a method of making a photoelectrode for solar water splitting, according to some embodiments.

### DETAILED DESCRIPTION

By seamlessly integrating III-nitride (such as InGaN-based) nanowires on both sides of the transparent conducting substrates or template substrate, having the same morphological nature, but better conductive properties than non-conducting and / or existing non-transparent substrates, one can pave the way for the realization of dual electrode overall water splitting applications (e.g., solar water splitting). Indium tin oxide (ITO) substrates, for example, have the same transparent characteristics as quartz, but of very high conductivity that can enable the formation of dual-sided growth of nanowires.

As one example, embodiments herein describe the fabrication of dual-sided photoelectrodes using n-InGaN nanowires as photoanode and p-GaN nanowires as photocathode that are separated by highly conductive ITO. The realization of this device can pave the way for the cost-effective production of hydrogen fuel. An example of growing nanowires on semi-transparent conductive-thin-film on transparent substrate is described herein on one side of a transparent substrate.

Embodiments of the present disclosure describe a phootoelectrode (e.g., for solar water splitting) comprising a first III-nitride nanowire layer, a transparent substrate in contact with the first nanowire layer at a first substrate surface, and a second III-nitride nanowire layer in contact with the substrate at a second substrate surface, substantially opposite the first substrate surface. The first and second III-nitride nanowire layers can be based on one or more of quantum disk or core-shell structure. For example, the active region of the first and/or second III-nitride nanowire layers may be based on either a quantum or core-shell structure. In many embodiments, the first III-nitride nanowire layer and the second III-nitride nanowire layer are different.

The transparent substrate can be conductive. The transparent substrate can be made of bulk transparent conducting substrate and/or a template substrate consisting of insulating substrate with ultra-thin metal (e.g., a thin conductive layer) deposited on both surfaces with multiple conducting channels through the insulating substrate. The substrate can be manufactured of, but not limited to, indium tin oxide (ITO), fluorine-doped tin oxide (FTO), and aluminum-doped zinc oxide (AZO).

Group III-nitride nanowires can include Ga, In, or Al, or their precursors. III-nitride compositions can include combinations of group III elements, such as GaN, AlN, InN, InGaN, AlGaN, or AlInGaN. In some embodiments, the nanowires or nanowire layers can include a dopant, such as a p-type or n-type. Examples of p-type dopants can include a dopant from Group II of the periodic table, such as Mg, Zn, Cd and Hg; or from Group IV. Examples of n-type dopants can include Si, Ge, Sn, S, Se and Te. In addition to III-nitride, semiconductors of other compounds can be used, such as binary, ternary, quaternary, or higher numbers of mixed elements compounds so long as they have a bandgap in the visible or infrared for maximizing solar spectrum absorption.

The first III-nitride layer and/or second III-nitride layer can be one or more of n-type nanowires and a p-type nanowires. In addition, the first III-nitride layer and/or second III-nitride layer may be provided as one or more of the photocathode and photoanode. For example, the first III-nitride layer can include n-InGaN nanowires as the photoanode and the second III-nitride layer includes p-GaN nanowires as the photocathode. Alternatively, the first III-nitride layer includes p-GaN nanowires as the photocathode and the second III-nitride layer includes n-InGaN nanowires as the photoanode. The nanowires can be spontaneously grown and are substantially vertical, for example. A nanowire generally refers to any elongated conductive or semiconductive material that includes at least one minor dimension, for example, one of the cross-sectional dimensions, such as width or diameter, of less than or equal to about 1000 nm. In various embodiments, the minor dimension can be less than about 100 nm or less than about 10 nm. The nanowires can have an aspect ratio of about 100 or greater or about 200 or greater. In other embodiments the aspect ratio can be 2000 or greater, for example. Nanowires can also include nanoshafts, nanopillars, nanoneedles, nanorods, and nanotubes, for example. The cross-sectional shapes of the nanowires can be rectangular, polygonal, square, oval, or circular, for example.

In one embodiment, thin conductive layers of material can be applied to enhance conductivity of the substrate and overall device. For example, a first thin conductive layer may be in contact with the transparent substrate at a first substrate surface. A first III-nitride nanowire layer may be grown or in contact with the first thin conductive layer. A second thin conductive layer may be in contact with the substrate at a second substrate surface, substantially opposite the first substrate surface; and a second III-nitride nanowire layer may be grown or in contact with the second thin conductive layer. The first and second thin conductive layers include one or more of ultrathin titanium, silver nanowire, graphene, and indium tin oxide, fluorine-doped tin oxide, or aluminum-doped zinc oxide, for example. The first and second thin conductive layers can be transparent or partially transparent, for example. The thin conductive layers may be used where the substrate is non-conductive, conductive, or partially to fully insulative. The substrate may include one or more conducting channels that are in electrical communication with one or more of the nanowire layers, the thin conductive layers, and the substrate.

Accordingly, embodiments of the present disclosure further describe a photoelectrode (e.g., for solar water splitting) comprising a first thin conductive layer; a transparent substrate, in contact with the first thin conductive layer at a first substrate surface; a first III-nitride nanowire layer in contact with the first thin conductive layer; a second thin conductive layer, in contact with the substrate at a second substrate surface, substantially opposite the first substrate surface; and a second III-nitride nanowire layer in contact with the second thin conductive layer.

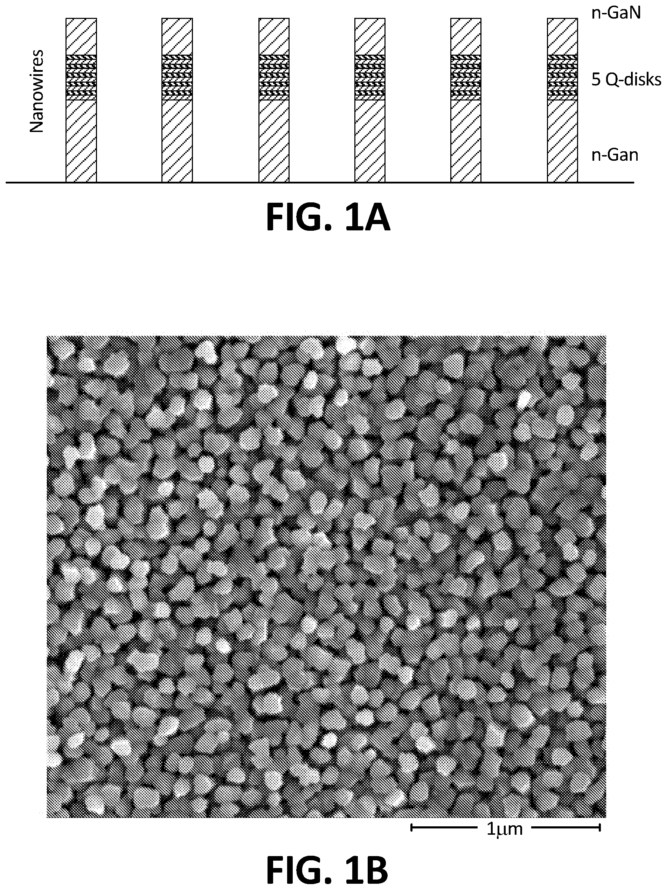

**FIGS. 1A-B** shows that the high-density nanowire array grows almost perpendicular to the substrate along the c-direction of GaN, typical of GaN nanowire grown using plasma assisted molecular beam epitaxy (PA-MBE). The nanowire array has an average diameter of -100 nm and average length of -300 nm. The density of the nanowire array is approximately 8.8×109 cm-2 with a fill factor of about 78%. The nanowire shows a tapered morphology with a narrow base and broad topside, attributed to temperature gradient along the nanowire. Thus, as the growth progresses, lateral growth is favored over axial growth.

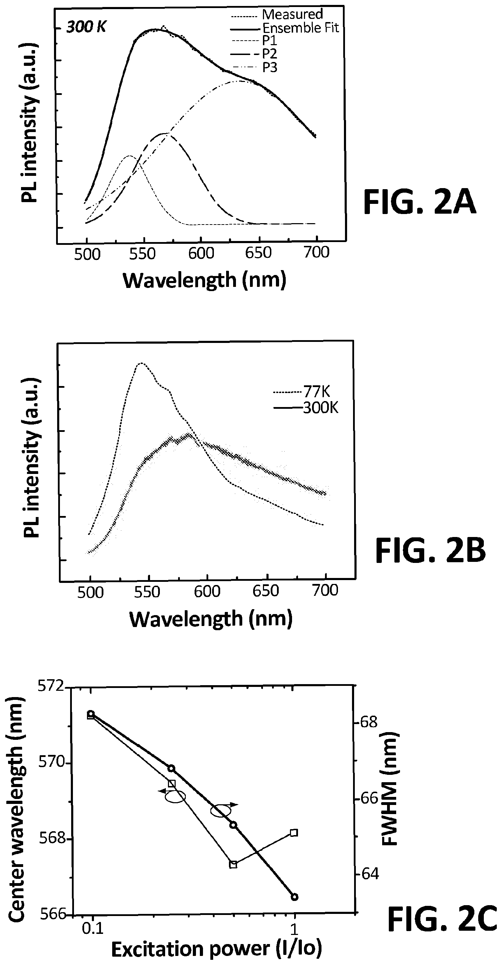

**FIGS. 2A-C** Light emission spectra (solid line) were collected using a confocal micro-Raman spectrometer (Horiba/Jobin Yvon Aramis), with the constituent subcomponents fitted (see legend: PI, P2, and P3 curves). A solid state laser of 473 nm wavelength was used as the excitation source. The laser beam was focused using a 50 × objective with numeric aperture NA = 0.5, and the spot size was about 1.5 µm. The sample was placed inside a cryostat cell (Linkam, THMS 600), and the temperature was changed from -195 to 300 °C with a stability of ± 0.1 °C. PL spectra at room temperature shows a broad peak centered around 570 nm. The broad emission wavelength is a common feature among III-Nitride materials due to structural and compositional inhomogeneity. Temperature dependent PL shows that at room the PL spectra red shifted and broadened with increasing temperature due to temperature related bandgap shrinkage and carrier redistribution between recombination centers. Power dependent photoluminescence experiment shows that the peak blueshifted with increasing pump fluence, mainly due to Coulomb screening effect of quantum confined stark effect and band filling effect.

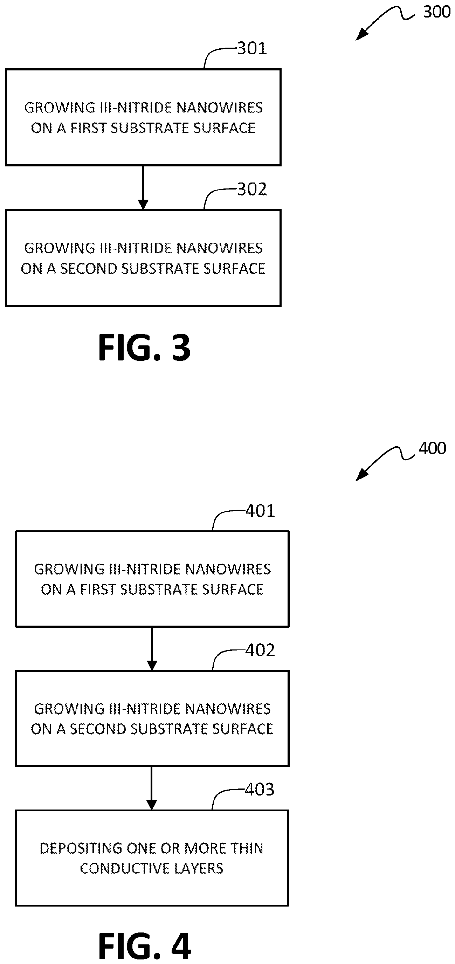

**FIG. 3** illustrates a block flow diagram of a method 300 of making a photoelectrode for solar water splitting, according to one or more embodiments of the present disclosure. As shown in **FIG. 3**, the method 300 may include growing 301 a first III-nitride nanowires on a first surface of a transparent, conducting substrate and growing 302 a second III-nitride nanowires on a second surface of the substrate, the second surface substantially opposing the first surface. The III-nitride nanowires on the first surface and the III-nitride nanowires on the second surface may be different.

Growing may be accomplished with PAMBE (plasma-assisted molecular beam epitaxy), MOCVD (metal organic chemical vapor deposition), OMVPE (organic metal vapor phase epitaxy), GSMBE (gas source molecular beam epitaxy), MOMBE (metal organic molecular beam epitaxy), ALE (atomic layer epitaxy), HVPE (hydride vapor phase epitaxy), LPE (liquid phase epitaxy), etc. These examples shall not be limiting as other techniques known in the art may be used for growing.

In some embodiments, the method 300 may further comprise depositing 303 (not shown) a first thin conductive layer between the III-nitride nanowires on the first surface and the first surface of the transparent substrate and/or a second thin conductive layer between the III-nitride nanowires on the second surface and the second surface of the transparent substrate. In general, if the substrate is conductive, the thin conductive layers may be optional. The first and/or second thin conductive layers may be one or more of semi-transparent, transparent, or not transparent. In many embodiments, the first and/or second thin conductive layers are semi-transparent.

For example, **FIG. 4** illustrates a block flow diagram of a method 400 of making a photoelectrode for solar water splitting, according to one or more embodiments of the present disclosure. As shown in **FIG. 4****,** the method 400 may include growing 401 III-nitride nanowires on a first surface of a substrate, growing 402 III-nitride nanowires on a second surface of the substrate, the second surface substantially opposing the first surface, and depositing 403 a first thin conductive layer between the III-nitride nanowires on the first surface and the first surface of the substrate and/or a second thin conductive layer between the III-nitride nanowires on the second surface and the second surface of the substrate. The substrates may be one or more of transparent and/or conductive. In many embodiments, the substrate is transparent only. In other embodiments, the substrate is transparent and conductive.

The order of the steps shall not be limiting, as steps 401 through 403 may be performed in any order. For example, one or more of the first thin conductive layer and the second thin conductive layer may be deposited before (or after) growing one or more of the III-nitride nanowires on the first surface and the III-nitride nanowires on the second surface. In another example, the method may comprise depositing a first thin conductive layer on a first surface of a transparent substrate, growing III-nitride nanowires on the first surface, depositing a second thin conductive layer on a second surface of a transparent substrate, and growing III-nitride nanowires on the second surface, the second surface substantially opposite the first surface.

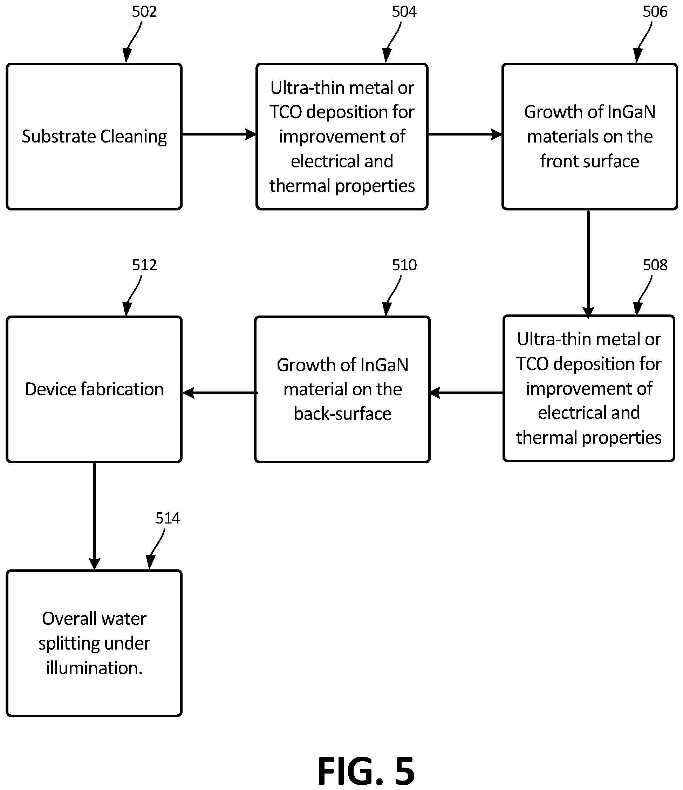

**FIG. 5** illustrates a block flow diagram of a method 500 of making a photoelectrode for solar water splitting, according to some embodiments. A transparent substrate is optionally cleaned 502. Cleaning can include chemical cleaning with solvents, for example. A first thin conductive layer is deposited 504 on a first surface of the transparent substrate. III-nitride nanowires are grown 506 on one or more of the first surface of the transparent substrate and the deposited first thin conductive layer. A second thin conductive layer is deposited 508 on a second surface of a transparent substrate. III-nitride nanowires are grown 510 on one or more of the second surface and the deposited second thin conductive layer, wherein the second surface is substantially opposite the first surface. The photoelectrode is further assembled 512 to solar water splitting 514.

In some embodiments, the method of making a photoelectrode for solar water splitting comprises depositing a first thin conductive layer on a first surface of a transparent substrate; growing III-nitride nanowires on the first surface; depositing a second thin conductive layer on a second surface of a transparent substrate; and growing III-nitride nanowires on the second surface, the second surface substantially opposite the first surface. In other embodiments, the method of making the photoelectrode for solar water splitting comprises growing III-nitride nanowires on a first surface of a transparent, conducting substrate; and growing III-nitride nanowires on a second surface of the substrate, the second surface substantially opposite the first surface.

## Claims

1. A photoelectrode, comprising:
a first III-nitride nanowire layer;
a transparent substrate, in contact with the first nanowire layer at a first substrate surface, wherein the transparent substrate is one or more of indium tin oxide, fluorine-doped tin oxide, and aluminum-doped zinc oxide; and
a second III-nitride nanowire layer, in contact with the substrate at a second substrate surface, substantially opposite the first substrate surface.

2. The photoelectrode according to claim 1, wherein the first and second III-nitride nanowire layers are based on one or more of quantum disk or core-shell structure.

3. The photoelectrode according to any one of claims 1-2, wherein the first and second III-nitride nanowire layers include one or more of GaN, AlN, InN, InGaN, AlGaN, and AlInGaN.

4. The photoelectrode according to any one of claims 1-3, wherein the first III-nitride nanowire layer and/or second III-nitride nanowire layer further includes a dopant.

5. The photoelectrode according to any one of claims 1-4, wherein the first III-nitride layer comprises n-InGaN nanowires as photoanode and the second III-nitride layer comprises p-GaN nanowires as photocathode.

6. The photoelectrode according to any one of claims 1-4, wherein the first III-nitride layer comprises p-GaN nanowires as photocathode and the second III-nitride layer comprises n-InGaN nanowires as photoanode.

7. A photoelectrode, comprising:
a first thin conductive layer;
a transparent substrate, in contact with the first thin conductive layer at a first substrate surface;
a first III-nitride nanowire layer in contact with the first thin conductive layer;
a second thin conductive layer, in contact with the substrate at a second substrate surface, substantially opposite the first substrate surface; and
a second III-nitride nanowire layer in contact with the second thin conductive layer.

8. The photoelectrode according to claim 7, wherein the substrate comprises an insulating material.

9. The photoelectrode of claim 8, further comprising conducting channels in the substrate.

10. The photoelectrode according to any one of claims 7-9, wherein the first and second thin conductive layers comprises one or more of silver nanowire, graphene, indium tin oxide, fluorine-doped tin oxide, aluminum-doped zinc oxide (AZO), or ultra-thin metal or two-dimensional (2D) materials allowing light to pass through sufficiently, thereby providing transparency or semi-transparency property.

11. The photoelectrode according to any one of claims 7-10, wherein the first and second III-nitride nanowire layers are based on one or more of quantum disk or core-shell structure.

12. The photoelectrode according to any one of claims 7-11, wherein the first and second thin conductive layers are transparent.

13. The photoelectrode according to any one of claims 7-12, wherein the first III-nitride layer comprises n-InGaN nanowires as photoanode and the second III-nitride layer comprises p-GaN nanowires as photocathode.

14. The photoelectrode according to any one of claims 7-12, wherein the first III-nitride layer comprises p-GaN nanowires as photocathode and the second III-nitride layer comprises n-InGaN nanowires as photoanode.

15. A method of making a photoelectrode for solar water splitting, comprising:
growing III-nitride nanowires on a first surface of a transparent, conducting substrate; and
growing III-nitride nanowires on a second surface of the substrate, the second surface substantially opposite the first surface; and
depositing a first thin conductive layer between the III-nitride nanowires on the first surface and the first surface of the transparent substrate and/or a second thin conductive layer between the III-nitride nanowires on the second surface and the second surface of the transparent substrate.

## Patentansprüche

1. Photoelektrode, die umfasst:
eine erste III-Nitrid-Nanodrahtschicht;
ein durchlässiges Substrat in Kontakt mit der ersten Nanodrahtschicht an einer ersten Substratoberfläche, wobei das durchlässige Substrat eines oder mehrere von Indiumzinnoxid, fluordotiertem Zinnoxid und aluminiumdotiertem Zinkoxid ist; und
eine zweite III-Nitrid-Nanodrahtschicht in Kontakt mit dem Substrat an einer zweiten Substratoberfläche, die der ersten Substratoberfläche im Wesentlichen gegenüberliegt.

2. Photoelektrode nach Anspruch 1, wobei die erste und die zweite III-Nitrid-Nanodrahtschicht auf einem oder mehreren einer Quantenscheiben- oder Kern-Schale-Struktur basiert sind.

3. Photoelektrode nach einem der Ansprüche 1 bis 2, wobei die erste und die zweite III-Nitrid-Nanodrahtschicht eines oder mehrere von GaN, AIN, InN, InGaN, AIGaN und AlInGaN beinhalten.

4. Photoelektrode nach einem der Ansprüche 1 bis 3, wobei die erste III-Nitrid-Nanodrahtschicht und/oder die zweite III-Nitrid-Nanodrahtschicht ferner ein Dotiermittel beinhaltet.

5. Photoelektrode nach einem der Ansprüche 1 bis 4, wobei die erste III-Nitrid-Schicht n-InGaN-Nanodrähte als Photoanode umfasst und die zweite III-Nitrid-Schicht p-GaN-Nanodrähte als Photokathode umfasst.

6. Photoelektrode nach einem der Ansprüche 1 bis 4, wobei die erste III-Nitrid-Schicht p-GaN-Nanodrähte als Photokathode umfasst und die zweite III-Nitrid-Schicht n-InGaN-Nanodrähte als Photoanode umfasst.

7. Photoelektrode, die umfasst:
eine erste leitfähige Dünnschicht;
ein durchlässiges Substrat in Kontakt mit der ersten leitfähigen Dünnschicht an einer ersten Substratoberfläche;
eine erste III-Nitrid-Nanodrahtschicht in Kontakt mit der ersten leitfähigen Dünnschicht;
eine zweite leitfähige Dünnschicht in Kontakt mit dem Substrat an einer zweiten Substratoberfläche, die der ersten Substratoberfläche im Wesentlichen gegenüberliegt; und
eine zweite III-Nitrid-Nanodrahtschicht, die mit der zweiten leitfähigen Dünnschicht in Kontakt steht.

8. Photoelektrode nach Anspruch 7, wobei das Substrat ein Isoliermaterial umfasst.

9. Photoelektrode nach Anspruch 8, die ferner leitende Kanäle in dem Substrat umfasst.

10. Photoelektrode nach einem der Ansprüche 7 bis 9, wobei die erste und die zweite leitfähige Dünnschicht eines oder mehrere von Silbernanodraht, Graphen, Indiumzinnoxid, fluordotiertem Zinnoxid, aluminiumdotiertem Zinkoxid (AZO) oder ultradünnen Metall- oder zweidimensionalen (2D-)Materialien umfasst, die ausreichend lichtdurchlässig sind, wodurch eine Eigenschaft der Durchlässigkeit oder Semidurchlässigkeit bereitgestellt wird.

11. Photoelektrode nach einem der Ansprüche 7 bis 10, wobei die erste und die zweite III-Nitrid-Nanodrahtschicht auf einem oder mehreren von Quantenscheiben- oder Kern-Schale-Struktur basiert sind.

12. Photoelektrode nach einem der Ansprüche 7 bis 11, wobei die erste und die zweite leitfähige Dünnschicht durchlässig sind.

13. Photoelektrode nach einem der Ansprüche 7 bis 12, wobei die erste III-Nitrid-Schicht n-InGaN-Nanodrähte als Photoanode umfasst und die zweite III-Nitrid-Schicht p-GaN-Nanodrähte als Photokathode umfasst.

14. Photoelektrode nach einem der Ansprüche 7 bis 12, wobei die erste III-Nitrid-Schicht p-GaN-Nanodrähte als Photokathode umfasst und die zweite III-Nitrid-Schicht n-InGaN-Nanodrähte als Photoanode umfasst.

15. Verfahren zum Herstellen einer Photoelektrode für solare Wasserspaltung, das umfasst:
Züchten von III-Nitrid-Nanodrähten auf einer ersten Oberfläche eines durchlässigen, leitenden Substrats; und
Züchten von III-Nitrid-Nanodrähten auf einer zweiten Oberfläche des Substrats, wobei die zweite Oberfläche der ersten Oberfläche im Wesentlichen gegenüberliegt; und Abscheiden einer ersten leitfähigen Dünnschicht zwischen den III-Nitrid-Nanodrähten auf der ersten Oberfläche und der ersten Oberfläche des durchlässigen Substrats und/oder einer zweiten leitfähigen Dünnschicht zwischen den III-Nitrid-Nanodrähten auf der zweiten Oberfläche und der zweiten Oberfläche des durchlässigen Substrats.

## Revendications

1. Photoélectrode, comprenant :
une première couche de nanofils de nitrure-III ;
un substrat transparent, en contact avec la première couche de nanofils au niveau d'une première surface de substrat, dans laquelle le substrat transparent est l'un ou plusieurs parmi l'oxyde d'indium-étain, l'oxyde d'étain dopé au fluor, et l'oxyde de zinc dopé à l'aluminium ; et
une deuxième couche de nanofils de nitrure-III, en contact avec le substrat au niveau d'une deuxième surface de substrat, sensiblement opposée à la première surface de substrat.

2. Photoélectrode selon la revendication 1, dans laquelle les première et deuxième couches de nanofils de nitrure-III sont basées sur l'une ou plusieurs parmi une structure de disque quantique ou de type noyau-enveloppe.

3. Photoélectrode selon l'une quelconque des revendications 1 à 2, dans laquelle les première et deuxième couches de nanofils de nitrure-III comprennent l'un ou plusieurs parmi GaN, AIN, InN, InGaN, AIGaN et AlInGaN.

4. Photoélectrode selon l'une quelconque des revendications 1 à 3, dans laquelle la première couche de nanofils de nitrure-III et/ou la deuxième couche de nanofils de nitrure-III comprend en outre un dopant.

5. Photoélectrode selon l'une quelconque des revendications 1 à 4, dans laquelle la première couche de nitrure-III comprend des nanofils de n-InGaN en tant que photoanode et la deuxième couche de nitrure-III comprend des nanofils de p-GaN en tant que photocathode.

6. Photoélectrode selon l'une quelconque des revendications 1 à 4, dans laquelle la première couche de nitrure-III comprend des nanofils de p-GaN en tant que photocathode et la deuxième couche de nitrure-III comprend des nanofils de n-InGaN en tant que photoanode.

7. Photoélectrode, comprenant :
une première couche conductrice mince ;
un substrat transparent, en contact avec la première couche conductrice mince au niveau d'une première surface de substrat ;
une première couche de nanofils de nitrure-III en contact avec la première couche conductrice mince ;
une deuxième couche conductrice mince, en contact avec le substrat au niveau d'une deuxième surface de substrat, sensiblement opposée à la première surface de substrat ; et
une deuxième couche de nanofils de nitrure-III en contact avec la deuxième couche conductrice mince.

8. Photoélectrode selon la revendication 7, dans laquelle le substrat comprend un matériau isolant.

9. Photoélectrode selon la revendication 8, comprenant en outre des canaux conducteurs dans le substrat.

10. Photoélectrode selon l'une quelconque des revendications 7 à 9, dans laquelle les première et deuxième couches conductrices minces comprend l'un ou plusieurs parmi un nanofil d'argent, un graphène, l'oxyde d'indium-étain, l'oxyde d'étain dopé au fluor, l'oxyde de zinc dopé à l'aluminium (AZO), ou des matériaux métalliques ultra-minces ou bidimensionnels (2D) laissant la lumière traverser suffisamment, de façon à conférer une propriété de transparence ou semi-transparence.

11. Photoélectrode selon l'une quelconque des revendications 7 à 10, dans laquelle les première et deuxième couches de nanofils de nitrure-III sont basées sur l'une ou plusieurs parmi une structure de disque quantique ou de type noyau-enveloppe.

12. Photoélectrode selon l'une quelconque des revendications 7 à 11, dans laquelle les première et deuxième couches conductrices minces sont transparentes.

13. Photoélectrode selon l'une quelconque des revendications 7 à 12, dans laquelle la première couche de nitrure-III comprend des nanofils de n-InGaN en tant que photoanode et la deuxième couche de nitrure-III comprend des nanofils de p-GaN en tant que photocathode.

14. Photoélectrode selon l'une quelconque des revendications 7 à 12, dans laquelle la première couche de nitrure-III comprend des nanofils de p-GaN en tant que photocathode et la deuxième couche de nitrure-III comprend des nanofils de n-InGaN en tant que photoanode.

15. Procédé de fabrication d'une photoélectrode pour séparation d'eau solaire, comprenant :
la croissance de nanofils de nitrure-III sur une première surface d'un substrat conducteur transparent ; et
la croissance de nanofils de nitrure-III sur une deuxième surface du substrat, la deuxième surface étant sensiblement opposée à la première surface ; et
le dépôt d'une première couche conductrice mince entre les nanofils de nitrure-III sur la première surface et la première surface du substrat transparent et/ou une deuxième couche conductrice mince entre les nanofils de nitrure-III sur la deuxième surface et la deuxième surface du substrat transparent.
